# FASCICULE DE BREVET EUROPEEN

(11) **EP 2 962 325 B1**
(45) Date de publication et mention de la délivrance du brevet: **16.11.2016**
(21) Numéro de dépôt: 14708622.7
(22) Date de dépôt: 12.02.2014
(51) Int. Cl.: H01L 33/00, H01L 23/00, H01L 21/18

(54) **PROCÉDÉ D'OBTENTION D'UNE SURFACE DE COLLAGE POUR COLLAGE DIRECT ET STRUCTURE CORRESPONDANTE**
VERFAHREN ZUR HERSTELLUNG EINER HAFTENDEN OBERFLÄCHE FÜR DIREKTE BINDUNG UND ZUGEHÖRIGE STRUKTUR
PROCESS FOR OBTAINING A BONDING SURFACE FOR DIRECT BONDING AND CORRESPONDING DEVICE

(30) Priorité: 28.02.2013 FR 1351799
(43) Date de publication de la demande: 06.01.2016
(73) Titulaire: Commissariat à l'Énergie Atomique et aux Énergies Alternatives, 75015 Paris (FR)
(72) Inventeur: BENAISSA, Lamine, F-91300 Massy (FR); GONDCHARTON, Paul, F-38100 Grenoble (FR); IMBERT, Bruno, F-38000 Grenoble (FR)
(74) Mandataire: Delorme, Nicolas
(86) Numéro de dépôt international: PCT/FR2014/050269
(87) Numéro de publication internationale: WO 2014/131960

(56) Documents cités:
- EP-A2- 1 684 340
- EP-A2- 2 006 887
- US-A1- 2009 286 382

## Description

La présente invention concerne un procédé d'obtention d'une surface de collage d'un substrat support métallique fritté en vue d'effectuer un collage direct sur un substrat receveur. L'invention concerne également une structure comprenant un substrat support métallique fritté collé par collage direct à un substrat receveur comprenant une couche fonctionnalisée d'un matériau semi-conducteur.

Dans l'industrie des matériaux semi-conducteurs, le collage métallique direct est une technologie largement employée pour assurer l'assemblage de deux substrats présentant des couches de collage métalliques et aboutir notamment à des structures 3D fonctionnalisées.

Le document US2009/286382 décrit un collage direct entre un substrat semi-conducteur et un substrat métallique. Pour ce faire, les surfaces des deux substrats sont tout d'abord polies et aplanies notamment par CMP pour atteindre la rugosité et la planarité souhaitées. Ensuite, les surfaces sont nettoyées pour enlever toute trace de contaminants, particules ou autres pouvant gêner le collage direct. Puis les surfaces propres sont activées notamment par traitement plasma ou par laser avant leur mise en contact, et l'ensemble est soumis à l'application d'une pression normale à l'interface et éventuellement un traitement thermique pour atteindre une énergie de collage satisfaisante.

Aujourd'hui dans un nombre croissant d'applications telles que l'éclairage, le photovoltaïque et la puissance, il apparait intéressant d'utiliser le collage direct pour assembler des substrats fonctionnalisés par des composants pour LEDs, cellules solaires, transistors ou diodes de puissance etc. avec des substrats métalliques massifs. Non seulement le collage direct est fiable mais l'utilisation d'un substrat métallique conducteur électrique et thermique offre de plus la possibilité de former une électrode commune aux composants, tout en permettant de fournir un puits de chaleur pour la dissipation thermique et/ou par exemple un blindage électromagnétique à l'image d'une cage de Faraday.

L'hétérostructure assemblée par collage direct est néanmoins sensible aux différences de coefficients de dilatation thermique (CTE acronyme anglais de Coefficient of Thermal Expansion) des différents matériaux mis en jeu. Il est donc avantageux de choisir un substrat métallique à base de matériaux qui présentent des CTE les plus proches possibles des matériaux semi-conducteurs les plus couramment utilisés, tels que le Si (3 ppm/K), le Ge (5.8 ppm/K), le SiC (2.7 ppm/K), le GaN (5.6 ppm/K). Les métaux de transitions réfractaires c'est-à-dire à haute température de fusion sont privilégiés tels que le Molybdène (7 ppm/K) ou le Tungstène (5.7 ppm/K) qui ont un CTE beaucoup plus faible que celui du Cuivre (17ppm/K) ou de l'Aluminium (23.1 ppm/K). De plus, ces matériaux présentent l'avantage d'avoir un très bon comportement à haute température, telle que 900°C, et une faible sensibilité à la corrosion.

La quasi-totalité des substrats massifs composés de ces métaux est obtenue par métallurgie des poudres, plus précisément par frittage (compactage de poudre) et seulement une faible proportion, par exemple 5 à 10 % des substrats de molybdène, est produite par électrofusion au four à arc à électrode consommable ou à bombardement électronique.

Les substrats électrofondus présentent une morphologie et des propriétés thermomécaniques beaucoup plus homogènes que celles des substrats frittés ce qui rend leur usinage, polissage et préparation beaucoup plus simple. Ces substrats électrofondus sont par exemple utilisés en tant que miroir (ie rugosité RMS, selon l'acronyme anglais Root Mean Square, < 1 nm) dans des applications très spécifiques (laser industriel, etc.) Cependant leur coût élevé rend leur utilisation impossible dans de nombreuses applications impliquant des composants à base de matériaux semi-conducteurs.

Pour ces applications, la meilleure option économique reste l'utilisation de substrats frittés. Cependant, le gain au niveau du coût du matériau se fait au détriment de la qualité de ces substrats frittés. En effet, ces derniers sont systématiquement polycristallins, présentent des grains inhomogènes en termes d'orientations, de taille (typiquement de 1 à 10 µm) et de propriétés mécaniques (dureté, densité etc.). Les substrats frittés sont par conséquent beaucoup plus difficiles à préparer, et notamment à polir, que des substrats de matériau électrofondu dont le comportement est beaucoup plus prévisible.

Pour préparer ces substrats frittés, différentes méthodes existent mais elles ne permettent pas d'obtenir un état de surface satisfaisant pour un collage métallique direct (rugosité < 1 nm RMS, absence de rayures, bonne planéité etc.) dans les fenêtres des procédés conventionnels.

Par exemple, le polissage mécanique permet d'obtenir de bons états de surface en termes de rugosité RMS mais il introduit de nombreux défauts dont la rayure est la principale manifestation.

Par ailleurs, le polissage mécano-chimique ne permet pas non plus d'obtenir un état de surface satisfaisant. Même si à l'échelle du grain une bonne rugosité est obtenue (rugosité < 1 nm RMS), l'action du réactif chimique reste extrêmement sensible à la nature et l'orientation des grains et il est extrêmement difficile de trouver des conditions stables pouvant à la fois autoriser le lissage et la planarisation de la surface. Des conditions très agressives (forte concentration en agent oxydant comme le H2O2 par exemple) occasionnent une dérive du procédé de polissage avec une dégradation de la planéité ; des conditions peu agressives aggravent la sélectivité, ce qui aboutit une révélation exacerbée des grains.

Une autre option de préparation de surface est de recouvrir le substrat d'un matériau beaucoup plus mou et facile à travailler tel que le cuivre. Un bon comportement est observé lors du polissage d'une couche de cuivre déposée sur un substrat de molybdène fritté ce qui rend possible un assemblage par collage direct avec un substrat receveur de silicium comprenant des composants. Néanmoins, une couche de cuivre est introduite dans la structure et du fait des différences de CTE entre les matériaux (Si//Cu//Mo), cette couche occasionne des problèmes de fiabilité et des modes de défaillance par fatigue de la structure.

La présente invention vise à pallier l'un ou plusieurs de ces inconvénients. A cet effet, la présente invention propose un procédé d'obtention d'une surface de collage d'un substrat support métallique fritté adaptée à un collage direct comprenant les étapes consistant à :
- a) Fournir un substrat de base métallique fritté présentant une surface de base comportant une rugosité RMS inférieure 6 nanomètres et une rugosité PV inférieure à 100 nanomètres,
- b) Bombarder d'espèces ioniques ladite surface de base,
- c) Déposer une couche métallique sur ladite surface de base, l'empilement dudit substrat de base et de ladite couche métallique formant le substrat support métallique, et
- d) Effectuer un polissage mécanique et/ou chimique d'une surface exposée de la couche métallique de sorte à obtenir la surface de collage adaptée au collage direct.

Par l'expression 'surface exposée de la couche métallique', on entend dans le présent document, la surface libre de la couche métallique déposée située du coté opposé à la surface en contact avec le substrat de base.

Grâce à cette combinaison d'étapes, le procédé de l'invention permet notamment d'obtenir un état de surface de collage rendant possible la réalisation d'un collage direct d'un substrat support métallique fritté sur un substrat receveur. Le collage obtenu présente une bonne tenue mécanique, compatible avec son intégration future.

L'étape b) de bombardement ionique de la surface de base agit comme un facteur d'homogénéisation des propriétés structurelles et mécaniques de la surface. Cette étape permet notamment d'isoler des propriétés structurelles et mécaniques du substrat de base de la couche métallique déposée ultérieurement à l'étape c) et limite la révélation des grains lors l'étape d) de polissage mécanique et/ou chimique de la surface exposée.

Sans vouloir être lié à une quelconque théorie scientifique il semble que l'effet d'homogénéisation de l'étape b) est double et que cette étape a une conséquence à la fois sur l'étape de dépôt c) et sur l'étape d) de polissage mécanique et/ou chimique.

L'hypothèse que l'on peut suggérer est que, sur le plan structurel, les ions accélérés par le bombardement bousculent les atomes ordonnés de la structure cristalline de la surface de base ce qui a pour effet d'amorphiser le matériau à la surface par création d'un chaos à l'échelle atomique composé de lacunes, d'interstitiels et de dislocations. Cette amorphisation de la surface est partielle ou totale et s'accompagne également d'une redistribution de la rugosité par l'arrachement de blocs de matière (composés de plusieurs atomes ayant une structure cristalline) et un re-dépôt naturel.

En procédant de la sorte, le chaos structurel interdit une reproduction exacte des propriétés structurelles des grains du substrat de base dans la couche métallique déposée à la surface de base. De plus le nivellement de la dureté du matériau en surface du substrat de base homogénéise le comportement de la couche métallique déposée vis-à-vis du procédé de polissage mécanique et/ou chimique. Ainsi les étapes c) et d) réalisées après l'étape b) permettent d'absorber la rugosité PV de la surface, par exemple en termes de rayures générées lors de la préparation du substrat de base, de lisser et de planariser la surface exposée.

Ainsi, si l'étape a) est suivie directement de l'étape c) et d) ou uniquement de l'étape d), une révélation des grains est observée à la surface conduisant à un état de surface incompatible avec la technique de collage direct. Il est donc important d'executer les étapes du procédé dans l'ordre indiqué.

Par ailleurs, si les étapes b) à d) sont réalisées sur un état de surface différent de celui du substrat de base de l'étape a) la rugosité de surface compatible avec un collage direct est plus difficilement obtenue.

Selon une disposition, l'étape b) de bombardement d'espèces ioniques est réalisée de sorte à amorphiser au moins en partie le métal sous la surface de base. Cette amorphisation du métal intervient alors dans le substrat de base à partir de la surface de base et sur une épaisseur inférieure ou égale à 10 nanomètres.

Avantageusement, l'étape d) est effectuée de sorte que la surface de collage présente une rugosité RMS inférieure 0,6 nanomètre et une rugosité PV inférieure à 10 nanomètres. Ces valeurs de rugosité permettent d'obtenir un très bon collage direct.

Dans le présent document, les valeurs de rugosité RMS (acronyme anglais de Root Mean Square) indiquées ont été mesurées sur un champ 5 micromètres x 5 micromètres, et les valeurs de rugosité PV (acronyme anglais de Peak to Valley) indiquées ont été mesurées sur un champ de 100*100µm².

Selon une possibilité, le procédé comprend avant l'étape a) une étape i) consistant à effectuer un polissage mécanique de la surface de base. Cette étape i) de polissage mécanique permet de planariser et de lisser la surface indépendamment de la nature chimique et cristalline du matériau travaillé. Elle permet de diminuer fortement et efficacement la rugosité jusqu'à atteindre 6 nm RMS et une rugosité PV inférieure à 100 nm. Comme cette étape ce polissage mécanique génère des défauts de surface caractéristiques, tels que des rayures, rendant impossible un collage direct, les étapes a) à d) successives sont indispensables pour l'obtention d'une couche à la surface adaptée au collage direct.

Avantageusement, la couche métallique déposée est formée du même matériau métallique que le substrat de base fritté. De ce fait, le matériau de la couche métallique déposée présente un CTE identique à celui du substrat de base ce qui évite la création de contraintes par des dilatations ou des contractions différentes selon les matériaux au cours de variations de températures.

De préférence, le procédé comprend une étape e) exécutée après l'étape d), comprenant un collage direct de la surface de collage sur une surface de réception d'un substrat receveur. Il est ainsi possible de former une structure stable dans la durée, comprenant deux substrats collés par collage direct, sans introduction de couche de matériau notamment de glue, adhésif, etc.., à l'interface de collage entre le substrat support métallique et le substrat receveur.

Selon une disposition, l'étape e) de collage direct est réalisée à température ambiante. En effet, la rugosité RMS et la rugosité PV obtenues par les étapes précédentes permettent un collage direct dans de très bonnes conditions. Il est alors possible d'obtenir un collage direct sans traitement thermique.

Avantageusement, le substrat receveur comporte au moins une couche fonctionnalisée de matériau semi-conducteur, à la surface de réception. La conduction thermique et électrique à l'interface du collage direct permet notamment de former une électrode commune aux composants fabriqués dans la couche fonctionnalisée de matériau semi-conducteur et un puits de chaleur pour améliorer la dissipation thermique. Elle assure également un blindage électromagnétique.

De préférence, la couche fonctionnalisée comprend un matériau monocristallin. Ainsi, les performances des dispositifs formés à partir de cette couche sont optimisées.

En variante, le substrat receveur est totalement formé d'un matériau monocristallin.

Selon une disposition, la couche fonctionnalisée de matériau semi-conducteur forme le substrat receveur.

De préférence, le matériau semi-conducteur de la couche fonctionnalisée est choisi parmi le silicium, le germanium, le SiGe, le SiC, ou des matériaux binaires, ternaires, quaternaires formés à partir des éléments III et V tels que le GaN, GaAs, InP, InGaN, et l'AlGaN. Beaucoup de composants peuvent être formés à partir de ces matériaux et leur CTE sont proches de ceux des métaux formant le substrat support métallique.

De préférence, les fonctionnalités de la couche fonctionnalisée de matériau semi-conducteur comprend des composants pour des LED's, des cellules solaires, des transistors ou des diodes de puissance. Une structure 3D fonctionnalisée peut ainsi être obtenue.

Selon une possibilité, le substrat de base comprend un matériau métallique fritté choisi parmi des métaux de transition réfractaires, de préférence le matériau métallique est choisi parmi le molybdène, le tungstène, le tantale, le niobium et le rhénium et les alliages de ces différents matériaux. Ces matériaux présentent avantageusement des CTE proches des matériaux semi-conducteurs les plus couramment utilisés. Ainsi, leur utilisation dans la fabrication de structures fonctionnalisées par collage direct allongent la longévité de la structure, permettent des traitements thermiques à des températures élevées et permettent de diminuer les coûts de fabrication par comparaison à l'utilisation de substrats métalliques fabriqués par électrofusion.

Selon une disposition, l'étape b) de bombardement d'espèces ioniques est réalisée avec une dose comprise entre 1^{E}13 et 5^{E}17 at/cm² par implantation ionique avec une énergie comprise entre 500eV et 250KeV ou par immersion plasma avec une énergie comprise entre 500eV et 50KeV. Ces conditions de bombardement permettent une amorphisation efficace du matériau à la surface de base tout en provoquant son durcissement structurel. L'épaisseur de matériau implanté est d'au moins 10 nm, typiquement de l'ordre de 20 nm. L'immersion plasma ayant une action plus superficielle, elle sera en général préférée à l'implantation ionique.

De préférence, les espèces ioniques sont obtenues à partir des éléments choisis parmi He, Ne, Ar, Kr, Xe. Ces espèces ioniques provenant de gaz rares ne réagissent pas avec le matériau implanté dans les conditions d'implantation (et notamment de doses) utilisées.

Il peut s'agir d'espèces ioniques simples telles que l'He⁺ ou multi-énergisées telles que l'He⁺⁺.

Avantageusement, l'étape c) de dépôt de la couche métallique est effectuée jusqu'à atteindre une épaisseur de couche supérieure ou égale à trois fois la rugosité PV de ladite surface de base obtenue à l'étape b). Une telle épaisseur de couche permet en effet de niveler la rugosité PV de la surface de base de sorte que les rayures formées par exemple à l'étape i) du procédé selon l'invention ne sont pas reproduites sur la surface exposée de la couche métallique déposée.

De préférence, l'étape c) de dépôt est effectuée à une température inférieure au tiers de la température de fusion du matériau métallique de la couche métallique déposée. Ainsi, les défauts crées à la surface de base par le bombardement ionique de l'étape b) ne sont pas restaurés par cet apport d'énergie thermique dans la couche métallique.

Selon un deuxième aspect, l'invention propose une structure, notamment pour des applications dans le domaine des LED's, de la puissance et du photovoltaïque, caractérisée en ce que la structure comprend successivement de sa base vers sa surface, un substrat de base fritté métallique dont la surface de base est formée au moins en partie d'un matériau métallique comprenant des espèces ioniques implantées par bombardement sur la surface de base, une couche métallique de compostion chimique identique à celle du substrat de base métallique, l'empilement du substrat de base et de la couche métallique formant un substrat support métallique fritté comportant une surface de collage présentant une rugosité RMS inférieure 0,6 nanomètres et une rugosité PV inférieure à 10 nanomètres.

L'obtention d'une surface de collage présentant une telle rugosité RMS et PV traduit l'utilisation de l'homognéisation des propriétés mécaniques et structurelles de la surface du substrat de base fritté en amont, ce qui permet ainsi un collage direct.

Avantageusement, la surface de collage est scellée directement à une surface de réception d'un substrat receveur par collage direct. Par l'expression 'scellée directement' on entend dans le présent document qu'il n'y a pas de matériau ni autre couche intermédiaire à l'interface de collage entre le substrat support métallique et le substrat receveur.

De préférence, le substrat receveur comprend au moins une couche fonctionnalisée de matériau semi-conducteur, de préférence monocristallin, à la surface de réception.

Le contact direct entre le substrat support métallique et la couche fonctionnalisée permet de faciliter la prise de contact électrique des composants formés dans la couche fonctionnalisée, facilite la dissipation thermique de la chaleur produite par le fonctionnement des composants tout en permettant un collage fiable sur la durée.

De préférence, le matériau métallique du substrat de base fritté est choisi parmi les métaux de transition réfractaires, de préférence le matériau métallique est choisi parmi le molybdène, le tungstène, le tantale, le niobium et le rhénium et les alliages de ces différents matériaux et la couche fonctionnalisée de matériau semi-conducteur formant le substrat receveur comprend du Si, du Ge, du SiGe, du SiC ou des matériaux binaires, ternaires, quaternaires formés à partir des éléments III et V tels que le GaN, GaAs, InP, InGaN, et l'AlGaN.

De la sorte, les matériaux utilisés présentent des CTE proches les uns des autres de sorte que la structure formée est peu sensible aux changements de températures. Par ailleurs, les matériaux des substrats métalliques utilisés étant peu coûteux, la fabrication d'une telle structure présente un coût de revient diminué de sorte qu'elle peut être utilisée dans de nombreuses applications, notamment pour des produits de grande consommation.

D'autres aspects, buts et avantages de la présente invention apparaîtront mieux à la lecture de la description suivante d'un mode de réalisation de celle-ci, donné à titre d'exemple non limitatif et fait en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.
- Les figures 1 à 5 illustrent de façon schématique une réalisation du procédé selon l'invention.
- La figure 6 illustre de façon schématique une structure fonctionnalisée résultante d'un collage direct selon un mode de réalisation du procédé de l'invention.

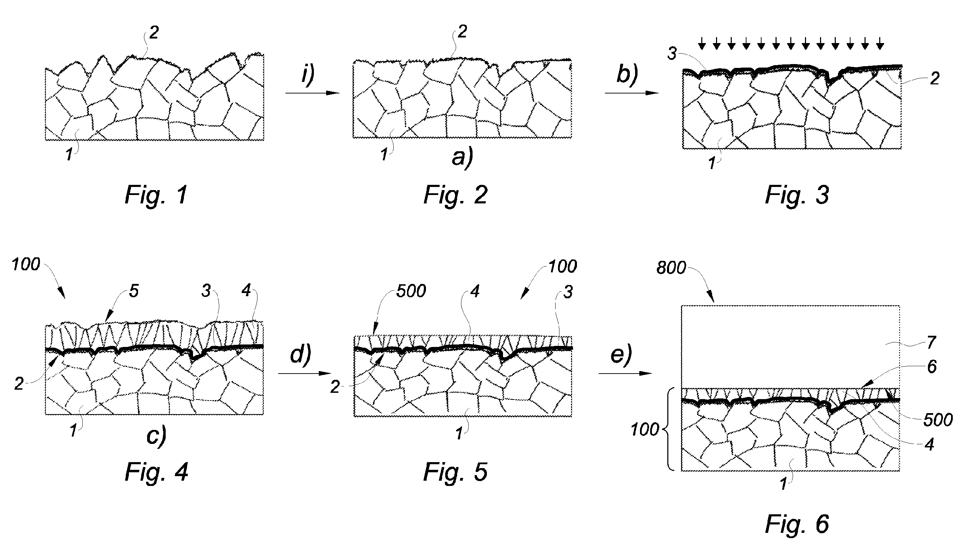

La figure 1 illustre un substrat de base 1 métallique massif de molybdène fritté dont la surface de base 2 présente une rugosité comprise entre 20 et 30 nanomètres RMS sur un champ de 5*5µm² et une rugosité PV comprise entre 150 et 250 nanomètres mesurée par interférométrie optique sur un champ de 100x100µm². Ces caractéristiques correspondent aux caractéristiques typiques des substrats frittés actuellement commercialisés.

Plus généralement, le substrat de base 1 peut être formé d'un métal fritté réfractaire tel que du molybdène, du tungstène, du tantale, du rhénium ou du niobium ou d'un alliage de ces métaux.

La figure 2 illustre l'étape i) du procédé consistant à effectuer un polissage mécanique sur la surface de base 2, par exemple avec une solution aqueuse de diamant sur un tapis abrasif. La rugosité RMS de la surface de base 2 obtenue après ce polissage est comprise entre 2 et 6 nanomètres, la rugosité PV de la surface de base 2 est comprise entre 25 et 100 nanomètres. Par ailleurs, le polissage sur le substrat de base 1 génère également des rayures à la surface de base 2, qui sont fonction de la technique de polissage mécanique employée. Ces rayures correspondent typiquement à des lignes courbes d'au moins 100µm de longueur (qui en général vont de bout en bout de la surface), avec une largeur de l'ordre de 500nm à 5µm et une profondeur en général supérieure à 100nm.

Selon une autre possibilité, le polissage mécanique peut être réalisé avec une solution aqueuse d'alumine sur un tapis abrasif.

La figure 3 illustre l'étape b) du procédé qui consiste à bombarder la surface de base 2 du substrat de base 1 de molybdène avec des espèces ioniques formées à base d'hélium avec une dose de 1^{E}16 at/cm² et une énergie de 10keV. Le bombardement est réalisé par implantation ionique, selon une variante, le bombardement peut être réalisé par immersion plasma. L'amorphisation d'au moins une partie du matériau métallique à la surface de base 2 du substrat de base 1 résultant du bombardement des espèces ioniques est schématiquement illustrée par un film 3 de matériau. Le matériau de ce film 3 a été homogénisé structurellement et mécaniquement parlant sur la surface de base 2 du substrat de base 1 mais il est entendu dans le présent document que l'homogénisation n'a pas obligatoirement lieu sur la totalité de la surface de base 2, que le film 3 peut être continu comme discontinu et que l'homogénisation peut être répartie très irrégulièrement en surface comme en profondeur. L'épaisseur de la zone implantée par bombardement est supérieure à 10 nm et typiquement de l'ordre de 20 nm.

Selon une variante de réalisation non illustrée, les espèces ioniques implantées peuvent être formées à base de Ne, Ar, Kr, Xe avec une dose comprise entre 1^{E}13 at/cm² et 5^{E}17 at/cm² et une énergie comprise entre 500eV et 250keV.

Selon encore une autre variante, le bombardement des espèces ioniques est obtenu par immersion plasma avec énergie comprise entre 500eV et 50keV.

La figure 4 illustre l'étape c) du procédé consistant à déposer une couche métallique 4 de molybdène par une technique de dépôt conventionnelle notamment par la technique PVD (acronyme anglais de Physical Vapor Deposition). La température du dépôt est d'environ 100°C de sorte à être inférieure au tiers de la température de fusion du matériau métallique et éviter la restauration des défauts crées par le bombardement ionique à la surface de base 2 sous-jacente. La couche métallique 4 est déposée sur environ un micromètre de sorte que son épaisseur est supérieure ou égale à au moins trois fois la rugosité PV de la surface de base 2 sur laquelle la couche métallique 4 est déposée. Il est ainsi possible de combler les irrégularités de la rugosité PV et d'éviter de la dupliquer à la surface exposée 5. La rugosité atteinte à la surface exposée 5 de la couche métallique 4 est ainsi comprise entre 2 et 6 nanomètres et la rugosité PV est comprise entre 25 et 100 nm.

Du fait de la présence du film 3 implantée en surface 2, le dépôt de la couche métallique 4 est décorelé des grains de surface du substrat de base 1. Le dépôt est à tendance colonnaire et les grains obtenus ont une taille limitée par l'épaisseur déposée et reste dans tous les cas plus petite que celle des grains du substrat de base 1.

Selon une autre possibilité, la couche métallique 4 déposée peut être constituée d'un autre matériau métallique que le Mo. De préférence, ce matériau peut être choisi parmi les métaux qui présentent un CTE proche de celui du substrat de base 1 fritté, par exemple le tungstène, le molybdène, le tantale, le rhénium, le niobium ou des alliages de ces métaux.

La figure 5 illustre l'étape d) du procédé consistant à effectuer un polissage mécano-chimique à la surface exposée 5 de la couche métallique 4 de Mo déposée de sorte à obtenir la surface de collage 500 adaptée au collage direct. A cet effet, une solution aqueuse de silice colloïdale comprenant un agent oxydant H2O2 est utilisée pour un polissage d'une durée d'environ trois minutes. La rugosité de la surface de collage 500 ainsi obtenue est d'environ 0.6 nanomètre et la rugosité PV de la surface 500 est d'environ 7 nanomètres. L'état de cette surface de collage 500 est alors compatible avec un collage métallique direct. On peut notamment obtenir un collage direct à température ambiante.

La figure 6 illustre l'étape e) du procédé consistant à mettre en contact et à coller la surface de collage 500 sur une surface de réception 6 d'un substrat receveur 7 en silicium massif pouvant avoir été fonctionnalisé au préalable, de sorte à obtenir une structure 800 fonctionnalisée avec embase métallique.

Selon une autre possibilité, le substrat receveur 7 peut comprendre un matériau semi-conducteur différent du silicium notamment choisi parmi le Ge, le SiC, le SiGe ou un matériau binaire, ternaire, quaternaire formé à partir des éléments III et V tels que le GaN, InGaN, et l'AlGaN.

Selon une variante non illustrée, le substrat receveur 7 peut comprendre une couche fonctionnalisée d'un matériau semi-conducteur à la surface de réception 6.

Les fonctionnalités du substrat receveur 7 peuvent notamment comprendre des composants pour LEDs, cellules solaires, transistors ou diodes de puissance.

Ainsi, la présente invention propose un procédé d'obtention d'une surface de collage 500 d'un substrat support métallique 100 peu coûteux en vue de réaliser un collage direct, par exemple à température ambiante, sur un substrat receveur 7 fonctionnalisé, comprenant notamment au moins une couche d'un matériau semi-conducteur, avantageusement monocristallin, de sorte à fabriquer à faible coût des structures 3D fonctionnelles 800 fiables dans le temps.

Il va de soi que l'invention n'est pas limitée aux variantes de réalisation décrites ci-dessus à titre d'exemples mais qu'elle comprend tous les équivalents techniques et les variantes des moyens décrits ainsi que leurs combinaisons.

## Revendications

1. Procédé d'obtention d'une surface de collage (500) d'un substrat support (100) métallique fritté adaptée à un collage direct comprenant les étapes consistant à :
- a) Fournir un substrat de base (1) fritté métallique présentant une surface de base (2) comportant une rugosité RMS inférieure 6 nanomètres et une rugosité PV inférieure à 100 nanomètres,
- b) Bombarder d'espèces ioniques ladite surface de base (2),
- c) Déposer une couche métallique (4) sur ladite surface de base (2), l'empilement dudit substrat de base (1) et de ladite couche métallique (4) formant le substrat support (100) métallique fritté, et
- d) Effectuer un polissage mécanique et/ou chimique d'une surface exposée (5) de la couche métallique (4) de sorte à obtenir la surface de collage (500) adaptée au collage direct.

2. Procédé selon la revendication 1 **caractérisé en ce que** l'étape d) est effectuée de sorte que la surface de collage (500) présente une rugosité RMS inférieure 0,6 nanomètre et une rugosité PV inférieure à 10 nanomètres.

3. Procédé selon l'une des revendications 1 à 2 **caractérisé en ce que** le procédé comprend avant l'étape a) une étape i) consistant à effectuer un polissage mécanique de la surface de base (2).

4. Procédé selon l'une des revendications 1 à 3 **caractérisé en ce que** la couche métallique (4) est formée du même matériau métallique que le substrat de base (1).

5. Procédé selon l'une des revendications 1 à 4 **caractérisé en ce que** le procédé comprend une étape e) exécutée après l'étape d), comprenant un collage direct de ladite surface de collage (500) sur une surface de réception (6) d'un substrat receveur (7).

6. Procédé selon la revendication 5, **caractérisé en ce que** le substrat receveur (7) comporte au moins une couche fonctionnalisée de matériau semi-conducteur, de préférence monocristallin, à la surface de réception (6).

7. Procédé selon l'une des revendications 1 à 6, **caractérisé en ce que** le substrat de base (1) comprend un matériau métallique fritté choisi parmi les métaux de transition réfractaires, de préférence le matériau métallique est choisi parmi le molybdène, le tungstène, le tantale, le niobium et le rhénium et les alliages de ces différents matériaux.

8. Procédé selon l'une des revendications 1 à 7, **caractérisé en ce que** l'étape b) de bombardement d'espèces ioniques est réalisée avec une dose comprise entre 1^{E}13 et 5^{E}17 at/cm² par implantation ionique avec une énergie comprise entre 500eV et 250KeV ou par immersion plasma avec une énergie comprise entre 500eV et 50KeV.

9. Procédé selon l'une des revendications 1 à 8, **caractérisé en ce que** les espèces ioniques sont obtenues à partir des éléments choisis parmi He, Ne, Ar, Kr, Xe.

10. Procédé selon l'une des revendications 1 à 9, **caractérisé en ce que** l'étape c) de dépôt de la couche métallique (4) est effectuée jusqu'à atteindre une épaisseur de couche métallique (4) supérieure ou égale à trois fois la rugosité PV de la surface de base (2) obtenue à l'étape b).

11. Procédé selon l'une des revendications 1 à 10, **caractérisé en ce que** l'étape c) de dépôt est effectuée à une température inférieure au tiers de la température de fusion du matériau de la couche métallique (4) déposée.

12. Structure (800), notamment pour des applications dans le domaine des LED's, de la puissance et du photovoltaïque, **caractérisée en ce que** la structure (800) comprend successivement de sa base vers sa surface, un substrat de base (1) fritté métallique dont la surface de base (2) est formée au moins en partie d'un matériau métallique comprenant des espèces ioniques implantées par bombardement sur la surface de base (2), une couche métallique (4) de compostion chimique identique à celle du substrat de base (1) métallique, l'empilement du substrat de base (1) et de la couche métallique (4) formant un substrat support métallique (100) fritté comportant une surface de collage (500) présentant une rugosité RMS inférieure 0,6 nanomètre et une rugosité PV inférieure à 10 nanomètres.

13. Structure (800) selon la revendication 12, **caractérisée en ce que** la surface de collage (500) est scellée directement à une surface de réception (6) d'un substrat receveur (7) par collage direct.

14. Structure (800) selon la revendication 13, **caractérisée en ce que** le substrat receveur (7) comprend au moins une couche fonctionnalisée de matériau semi-conducteur, de préférence monocristallin, à la surface de réception (6).

15. Structure (800) selon la revendication 14, **caractérisée en ce que** le matériau métallique du substrat de base fritté (1) est choisi parmi les métaux de transition réfractaires, de préférence le matériau métallique est choisi parmi le molybdène, le tungstène, le tantale, le niobium et le rhénium et les alliages de ces différents matériaux et **en ce que** la couche fonctionnalisée de matériau semi-conducteur forme le substrat receveur (7) et comprend du Si, du Ge, du SiGe, du SiC ou des matériaux binaires, ternaires, quaternaires formés à partir des éléments III et V tels que le GaN, GaAs, InP, InGaN, et l'AlGaN.

## Patentansprüche

1. Verfahren zum Erhalten einer Klebeoberfläche (500) eines gesinterten metallischen Trägersubstrats (100), das für ein direktes Kleben angepasst ist, das die Schritte umfasst, die aus Folgendem bestehen:
- a) Liefern eines gesinterten metallischen Basissubstrats (1), das eine Basisoberfläche (2) aufweist, die eine RMS-Rauheit kleiner als 6 Nanometer und eine PV-Rauheit kleiner als 100 Nanometer umfasst,
- b) Beschießen der Basisoberfläche (2) mit ionischen Spezies,
- c) Ablagern einer Metallschicht (4) auf der Basisoberfläche (2), wobei die Stapelung des Basissubstrats (1) und der Metallschicht (4) das gesinterte metallische Trägersubstrat (100) bildet, und
- d) Ausführen eines mechanischen und/oder chemischen Polierens einer exponierten Oberfläche (5) der Metallschicht (4) derart, dass eine Klebeoberfläche (500), die an das direkte Kleben angepasst ist, erhalten wird.

2. Verfahren nach Anspruch 1, **dadurch gekennzeichnet, dass** der Schritt d) derart ausgeführt wird, dass die Klebeoberfläche (500) eine RMS-Rauheit kleiner als 0,6 Nanometer und eine PV-Rauheit kleiner als 10 Nanometer aufweist.

3. Verfahren nach einem der Ansprüche 1 bis 2, **dadurch gekennzeichnet, dass** das Verfahren vor dem Schritt a) einen Schritt i) umfasst, der darin besteht, ein mechanisches Polieren der Basisoberfläche (2) auszuführen.

4. Verfahren nach einem der Ansprüche 1 bis 3, **dadurch gekennzeichnet, dass** die Metallschicht (4) aus dem gleichen Metallwerkstoff wie das Basissubstrat (1) gebildet ist.

5. Verfahren nach einem der Ansprüche 1 bis 4, **dadurch gekennzeichnet, dass** das Verfahren einen Schritt e) umfasst, der nach dem Schritt d) ausgeführt wird, der ein direktes Kleben der Klebeoberfläche (500) auf eine Oberfläche (6) zum Aufnehmen eines Aufnehmersubstrats (7) umfasst.

6. Verfahren nach Anspruch 5, **dadurch gekennzeichnet, dass** das Aufnehmersubstrat (7) mindestens eine funktionalisierte Schicht aus Halbleiterwerkstoff, der vorzugsweise monokristallin ist, an der Aufnahmeoberfläche (6) zum Aufnehmen umfasst.

7. Verfahren nach einem der Ansprüche 1 bis 6, **dadurch gekennzeichnet, dass** das Basissubstrat (1) einen gesinterten metallischen Werkstoff umfasst, der aus den Feuerfest-Übergangsmetallen ausgewählt ist, wobei der Metallwerkstoff vorzugsweise aus Molybdän, Wolfram, Tantal, Niob und Rhenium sowie Legierungen dieser unterschiedlichen Werkstoffe ausgewählt ist.

8. Verfahren nach einem der Ansprüche 1 bis 7, **dadurch gekennzeichnet, dass** der Schritt b) des Beschießens mit ionischen Spezies mit einer Dosis, die zwischen 1^{E}13 und 5^{E}17 at/cm² durch Ionenimplantation mit einer Energie zwischen 500 eV und 250 keV ausgeführt wird, oder durch Plasma-Immersion mit einer Energie zwischen 500 eV und 50 keV ausgeführt wird.

9. Verfahren nach einem der Ansprüche 1 bis 8, **dadurch gekennzeichnet, dass** die ionischen Spezies ausgehend von Elementen erhalten werden, die aus He, Ne, Ar, Kr, Xe ausgewählt sind.

10. Verfahren nach einem der Ansprüche 1 bis 9, **dadurch gekennzeichnet, dass** der Schritt c) des Ablagerns der Metallschicht (4) erfolgt, bis eine Stärke der Metallschicht (4) größer oder gleich drei Mal die PV-Rauheit der Basisoberfläche (2), die bei Schritt b) erhalten wird, erreicht wird.

11. Verfahren nach einem der Ansprüche 1 bis 10, **dadurch gekennzeichnet, dass** der Schritt c) des Ablagerns bei einer Temperatur kleiner als ein Drittel der Fusionstemperatur des Werkstoffs der abgelagerten Metallschicht (4) ausgeführt wird.

12. Struktur (800), insbesondere für Anwendungen in dem Bereich der LEDs, der Leistung und der Fotovoltaik, **dadurch gekennzeichnet, dass** die Struktur (800) nacheinander von ihrer Basis zu ihrer Oberfläche ein gesintertes metallisches Basissubstrat (1), dessen Basisoberfläche (2) mindestens zum Teil aus einem Metallwerkstoff gebildet ist, der ionische Spezies umfasst, die durch Beschießen auf der Basisoberfläche (2) implantiert werden, eine Metallschicht (4) mit chemischer Zusammensetzung, die mit der des metallischen Basissubstrats (1) identisch ist, umfasst, wobei die Stapelung des Basissubstrats (1) und der Metallschicht (4) einen gesinterten metallischen Substratträger (100) bildet, der eine Klebeoberfläche (500) umfasst, die eine RMS-Rauheit kleiner als 0,6 Nanometer und eine PV-Rauheit kleiner als 10 Nanometer aufweist.

13. Struktur (800) nach Anspruch 12, **dadurch gekennzeichnet, dass** die Klebeoberfläche (500) direkt auf einer Oberfläche (6) zum Aufnehmen eines Aufnehmersubstrats (7) durch direktes Kleben versiegelt wird.

14. Struktur (800) nach Anspruch 13, **dadurch gekennzeichnet, dass** das Aufnehmersubstrat (7) mindestens eine funktionalisierte Schicht aus Halbleiterwerkstoff, der vorzugsweise monokristallin ist, auf der Aufnahmeoberfläche (6) umfasst.

15. Struktur (800) nach Anspruch 14, **dadurch gekennzeichnet, dass** der Metallwerkstoff des gesinterten Basissubstrats (1) aus den Feuerfest-Übergangsmetallen ausgewählt ist, wobei der Metallwerkstoff vorzugsweise aus Molybdän, Wolfram, Tantal, Niob und Rhenium und den Legierungen dieser unterschiedlichen Werkstoffe ausgewählt ist, und dass die funktionalisierte Schicht aus Halbleiterwerkstoff das Aufnehmersubstrat (7) bildet und Si, Ge, SiGe, SiC oder binäre, ternäre, quaternäre Werkstoffe umfasst, die ausgehend von den Elementen III und V, wie zum Beispiel GaN, GaAs, InP, InGaN und AlGaN gebildet sind.

## Claims

1. A method for obtaining a bonding surface (500) of a sintered metal support substrate (100) adapted to a direct bonding comprising the steps consisting of:
a) Providing a sintered metal base substrate (1) having a base surface (2) including an RMS roughness less than 6 nanometers and a PV roughness less than 100 nanometers,
b) Bombarding said base surface (2) with ionic species,
c) Depositing a metal layer (4) on said base surface (2), the stack of said base substrate (1) and said metal layer (4) forming the sintered metal support substrate (100),
and
d) Performing a mechanical and/or chemical polishing of an exposed surface (5) of the metal layer (4) so as to obtain the bonding surface (500) adapted to the direct bonding.

2. The method according to claim 1 **characterized in that** step d) is performed so that the bonding surface (500) has an RMS roughness less than 0.6 nanometer and a PV roughness less than 10 nanometers.

3. The method according to any of claims 1 to 2 **characterized in that** the method comprises, prior to step a), a step i) consisting of performing a mechanical polishing of the base surface (2).

4. The method according to any of claims 1 to 3 **characterized in that** the metal layer (4) is formed of the same metal material as the base substrate (1).

5. The method according to any of claims 1 to 4 **characterized in that** the method comprises a step e) carried out after step d), comprising a direct bonding of said bonding surface (500) on a receiving surface (6) of a receiver substrate (7).

6. The method according to claim 5, **characterized in that** the receiver substrate (7) includes at least one functionalized layer of monocrystalline semiconductor material, preferably of monocrystalline semiconductor material, to the receiving surface (6).

7. The method according to any of claims 1 to 6, **characterized in that** the base substrate (1) comprises a sintered metal material selected from refractory transition metals, preferably the metal material is selected from molybdenum, tungsten, tantalum, niobium and rhenium and alloys of these different materials.

8. The method according to any of claims 1 to 7, **characterized in that** the step b) for bombarding ionic species is made with a dose comprised between 1^{E}13 and 5^{E}17 at/cm² by ionic implantation with an energy comprised between 500 eV and 250 KeV or by plasma immersion with an energy comprised between 500 eV and 50 KeV.

9. The method according to any of claims 1 to 8, **characterized in that** the ionic species are obtained from elements selected from He, Ne, Ar, Kr, Xe.

10. The method according to any of claims 1 to 9, **characterized in that** the step c) for depositing the metal layer (4) is performed until reaching a thickness of metal layer (4) greater than or equal to three times the PV roughness of the base surface (2) obtained in step b).

11. The method according to any of claims 1 to 10, **characterized in that** the deposition step c) is performed at a temperature lower than one third of the melting temperature of the material of the deposited metal layer (4).

12. A structure (800), in particular for applications in the field of LED's, power and photovoltaics, **characterized in that** the structure (800) comprises successively from its base to its surface, a sintered metal base substrate (1) whose base surface (2) is formed at least partially of a metal material comprising ionic species implanted by bombardment on the base surface (2), a metal layer (4) of identical chemical composition to that of the metal base substrate (1), the stack of the base substrate (1) and the metal layer (4) forming a sintered metal support substrate (100) including a bonding surface (500) having an RMS roughness less than 0.6 nanometer and a PV roughness less than 10 nanometers.

13. The structure (800) according to claim 12, **characterized in that** the bonding surface (500) is sealed directly to a receiving surface (6) of a receiver substrate (7) by direct bonding.

14. The structure (800) according to claim 13, **characterized in that** the receiver substrate (7) comprises at least one functionalized layer semiconductor material, preferably monocrystalline semiconductor material, to the receiving surface (6).

15. The structure (800) according to claim 14, **characterized in that** the metal material of the sintered base substrate (1) is selected from the refractory transition metals, preferably the metal material is selected from molybdenum, tungsten, tantalum, niobium and rhenium and alloys of these different materials and **in that** the functionalized layer of semiconductor material forms the receiver substrate (7) and comprises Si, Ge, SiGe, SiC or binary, ternary, quaternary materials formed from III and V elements such as GaN, GaAs , InP, InGaN, and AlGaN.
